# EUROPÄISCHE PATENTSCHRIFT

(11) **EP 0 691 545 B1**
(45) Veröffentlichungstag und Bekanntmachung des Hinweises auf die Patenterteilung: **26.04.2000**
(21) Anmeldenummer: 95103331.5
(22) Anmeldetag: 08.03.1995
(51) Int. Cl.: G01R 19/25

(54) **Verfahren und Messanordnung in digitalen Systemen zum Messen von Wechselspannung, Wechselstrom und Phasenwinkel eines Messsignals**
Process and appliance in digital systems for measuring alternating voltage, current and phase angle of a signal
Procédé et dispositif de mesure dans des systèmes digitaux pour la mesure de la tension alternative, du courant alternatif et le déphasage d'un signal de mesure.

(30) Priorität: 08.07.1994 DE 4424059
(43) Veröffentlichungstag der Anmeldung: 10.01.1996
(73) Patentinhaber: MASCHINENFABRIK REINHAUSEN GmbH, 93059 Regensburg (DE)
(72) Erfinder: Okanik, Peter, Dipl. Ing., D-93128 Regenstauf (DE); Kugler, Kurt, Dipl. Ing., D-93138 Hainsacker (DE)

(56) Entgegenhaltungen:
- EP-A- 0 243 835

## Beschreibung

Die Erfindung betrifft ein Verfahren gemäß Patentanspruch 1.

Ein solches Verfahren und eine zur Durchführung geeignete Meßanordnung sind aus der DE-PS 36 14 419 bereits bekannt.

Bei dem bekannten Verfahren wird dem zu erfassenden Meßsignal eine Gleichspannung als Referenzspannung überlagert und damit der Nulldurchgang in einen besser erfaßbaren Spannungsbereich verschoben. Bei der bekannten Meßanordnung sind jeweils ein Pol von Spannungs- und Stromwandler an das Potential der Referenzspannung geschaltet, die einem Multiplexer als Bezugsgröße aufgeschaltet ist. Dieser wiederum ist mit einem A/D-Wandler verbunden. Bei diesem bekannten Verfahren werden hohe Anforderungen an die Genauigkeit des A/D-Wandlers gestellt, da dieser stets im gleichen, durch die Höhe der Referenzspannung festgelegten, Arbeitspunkt arbeitet. Weist der jeweilige A/D-Wandler Ungenauigkeiten bzw. Nichtlinearitäten auf, kann dies dazu führen, daß der Arbeitspunkt eine gewisse Inkonstanz aufweist und damit der jeweilige Meßwert um +/- 1 Bit verfälscht werden kann. Bei industriellen Anwendungen ist man aus Kostengründen nun gerade bestrebt, möglichst einfache, preiswerte und damit mit gewissen Nichtlinearitäten behaftete kommerziell angebotene A/D-Wandler einsetzen zu können. Mit diesen führt das bekannte Verfahren zu den beschriebenen Meßfehlern.

Aufgabe der Erfindung ist es demnach, ein gattungsgemäßes Verfahren anzugeben, wobei genaue Messungen auch bei toleranzbehafteten, um einen Arbeitspunkt driftenden A/D-Wandler möglich sein sollen.

Diese Aufgabe wird erfindungsgemäß durch ein Verfahren mit den Merkmalen des ersten Patentanspruches gelöst.

Der Vorteil des erfindungsgemäßen Verfahrens besteht im wesentlichen darin, daß dadurch, daß der ursprünglich aufgeschalteten Gleichspannung als Referenzspannung eine sich zeitlich ändernde weitere Spannung überlagert wird, während einer Halbwelle praktisch der gesamte Arbeitsbereich des A/D-Wandlers durchlaufen wird. Dadurch werden Ungenauigkeiten bzw. Nichtlinearitäten kompensiert; der A/D-Wandler verharrt nicht - wie nach dem Stand der Technik üblich - auf dem gleichen Arbeitspunkt während des gesamten Meßintervalles, d. h. der gesamten Halbwelle.

Die Erfindung soll nachstehend anhand von Zeichnungen beispielhaft noch näher erläutert werden.

Figur 1 zeigt den Signalverlauf beim erfindungsgemäßen Verfahren.

Figur 2 zeigt eine Meßanordnung zur Durchführung dieses Verfahrens, bei der durch ein an sich bekanntes RC-Glied im Rückkopplungszweig eine kontinuierlich während einer Halbwelle zunehmende, einem Sägezahn angenäherte Spannung erzeugt wird, die der Referenzspannung überlagerbar ist.

Der Meßgröße, hier der Meßspannung U wird eine Referenzspannung URef als Gleichgröße, wie nach dem Stand der Technik bekannt, überlagert. Weiterhin wird eine weitere Spannung URef* erzeugt, die während der positiven Halbwelle der Meßspannung U kontinuierlich zunimmt und während der negativen Halbwelle der Meßspannung U kontinuierlich abnimmt. Diese Spannung URef* wird ebenfalls der Spannung U überlagert; es ergibt sich die resultierende zu messende Spannung UM. Die Verarbeitung dieser Spannung UM erfolgt auf bekannte Weise durch einen nachgeordneten Multiplexer M und dem nachgeschalteten A/D-Wandler.

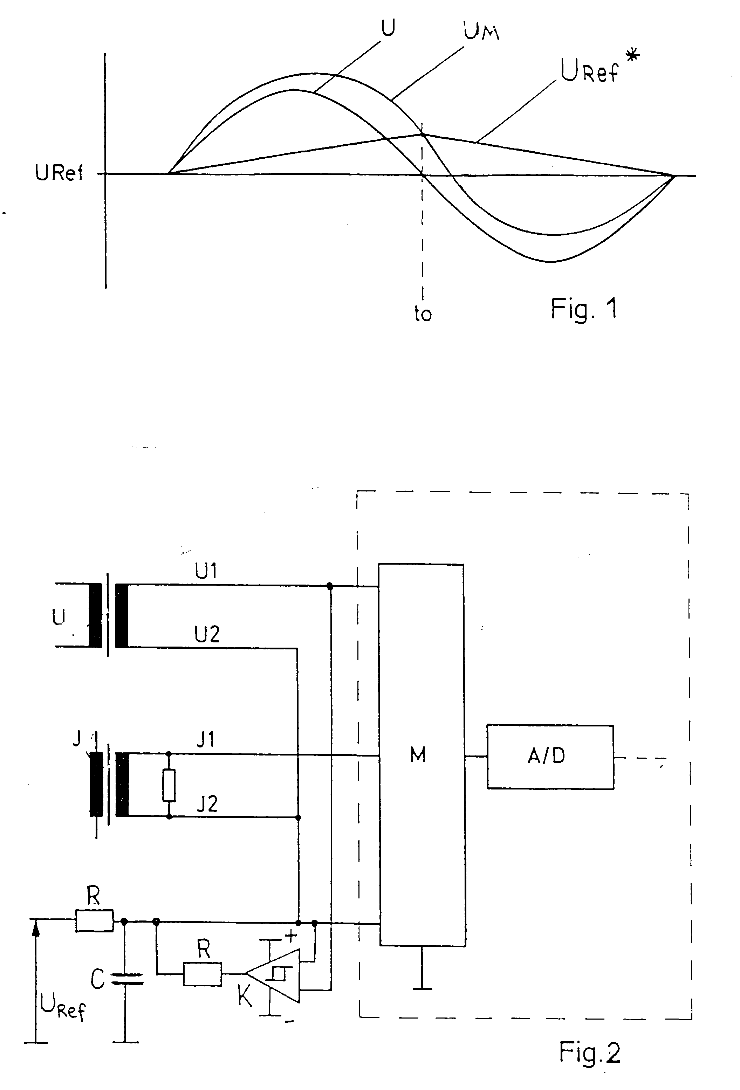

Figur 2 zeigt eine für dieses erfindungsgemäße Verfahren besonders geeignete Meßanordnung. Die zu messende Größe, hier die Meßspannung U, wird auf einen Komperator K geschaltet, der den Nulldurchgang von U erfaßt und in Abhängigkeit davon eine Gleichspannung UKomp mit zwei unterschiedlichen Amplituden erzeugt, die auf an sich bekannte Weise auf ein RC-Glied geführt wird, derart, daß eine Spannung URef* erzeugt wird, die in ihrem zeitlichen Verlauf eine e-Funktion beschreibt und der Referenzspannung URef überlagert wird.

## Patentansprüche

1. Verfahren in digitalen Systemen zum Messen von Wechselspannung, Wechselstrom und Phasenwinkel eines Meßsignals, wobei der Nulldurchgang dieses Meßsignals dadurch erfaßt wird, daß dem eigentlichen Meßsignal (U) eine Gleichspannung als Referenzspannung (URef) überlagert wird,
**dadurch gekennzeichnet,**
daß der Nulldurchgang des Meßsignales (U) bezogen auf das Potential der Referenzspannung (URef) erfaßt wird,
daß eine weitere Spannung (URef*) erzeugt wird, die während der positiven Halbwelle des Meßsignals (U) kontinuierlich zunimmt und während der negativen Halbwelle des Meßsignals (U) kontinuierlich abnimmt
und daß diese weitere Spannung (URef*) der Referenzspannung (URef) und damit dem Meßsignal (U) überlagert wird.

## Claims

1. Method in digital systems for measuring alternating voltage, alternating current and phase angle of a measurement signal, wherein the zero transition of this measurement signal is detected thereby that a direct voltage is superimposed as a reference voltage (URef) on the actual measurement signal (U), characterised in that the zero transition of the measurement signal (U) with respect to the potential of the reference voltage (URef) is detected, that a further voltage (URef*) is generated which continuously increases during the positive half wave of the measurement signal (U) and continuously decreases during the negative half wave of the measurement signal (U) and that this further voltage (URef*) is superimposed on the reference voltage (URef) and thus on the measurement signal (U).

## Revendications

1. Procédé dans des systèmes numériques de mesure de la tension ou du courant alternatifs et de l'angle de phase d'un signal de mesure, selon lequel on saisit le passage par zéro de ce signal de mesure et on superpose au signal de mesure proprement dit (U), une tension continue comme tension de référence (Uref),
caractérisé en ce que
on détecte le passage par zéro du signal de mesure (U) rapporté au potentiel de la tension de référence (Uref),
on génère une autre tension (Uref*) qui augmente en continu pendant la demi-onde positive du signal de mesure (U) et diminue en continu pendant la demi-onde négative du signal de mesure (U) et,
cette autre tension (Uref*) est superposée à la tension de référence (Uref) et ainsi au signal de mesure (U).
